# FASCICULE DE BREVET EUROPEEN

(11) **EP 4 490 990 B1**
(45) Date de publication et mention de la délivrance du brevet: **11.02.2026**
(21) Numéro de dépôt: 23707978.5
(22) Date de dépôt: 03.03.2023
(51) Int. Cl.: H10N 30/073, H03H 9/02, H03H 3/08

(54) **SUBSTRAT PIÉZOÉLECTRIQUE SUR ISOLANT (POI) ET PROCÉDÉ DE FABRICATION D'UN SUBSTRAT PIÉZOÉLECTRIQUE SUR ISOLANT (POI)**
PIEZOELEKTRIKUM-AUF-ISOLATOR (POI)-SUBSTRAT UND VERFAHREN ZUR HERSTELLUNG EINES PIEZOELEKTRIKUM-AUF-ISOLATOR (POI)-SUBSTRATS
PIEZOELECTRIC-ON-INSULATOR (POI) SUBSTRATE AND METHOD FOR PRODUCING A PIEZOELECTRIC-ON-INSULATOR (POI) SUBSTRATE

(30) Priorité: 08.03.2022 FR 2202034
(43) Date de publication de la demande: 15.01.2025
(73) Titulaire: SOITEC, 38190 Bernin (FR)
(72) Inventeur: DROUIN, Alexis, 38190 Bernin (FR)
(74) Mandataire: IP Trust
(86) Numéro de dépôt international: PCT/EP2023/055478
(87) Numéro de publication internationale: WO 2023/169962

(56) Documents cités:
- CN-A- 113 014 218
- US-A1- 2020 313 643

## Description

L'invention concerne un substrat piézoélectrique sur isolant (POI) et un procédé de fabrication d'un tel substrat piézoélectrique sur isolant (POI).

Un substrat piézoélectrique sur isolant (POI) comprend une couche mince de matériau piézoélectrique sur un substrat support assemblé ensemble par une couche diélectrique d'oxyde de silicium qui procure une bonne adhésion entre la couche de matériau piézoélectrique et le substrat support.

De tels substrats sont utilisés pour des dispositifs à ondes acoustiques, tel capteurs ou filtres. Ces dispositifs ont de bonnes performances grâce à des valeurs de qualité Q et de coefficients de couplage électromécanique *k*² plus élevées comparées à d'autres substrats de l'état de l'art. CN 113014218 A divulgue un substrat POI dans lequel la composition d'une couche en SiOₓN₁₋ₓ gradué (linéairement) à l'interface avec le substrat support (Si) est Si₃N₄ et la composition à l'interface avec la couche piézoélectrique (LiTaO₃) est SiO₂. L'impédance acoustique varie de manière continue dans cette couche graduée. US 2020/0313643 A1 décrit un substrat POI similaire dans lequel la concentration en azote de la partie intermédiaire d'une couche de liaison en oxyde de silicium est supérieure aux concentrations en azote des parties situées du côté de la couche piézoélectrique et du côté du substrat support.

Cependant, le matériau du substrat support étant à base de silicium, il existe une différence importante entre l'impédance acoustique du substrat support et celle de la couche diélectrique d'oxyde de silicium. Cette différence d'impédance acoustique dans la structure du substrat piézoélectrique engendre une perte des performances du dispositif à ondes acoustiques fabriqué sur le substrat POl. En effet, la différence d'impédance acoustique entre le substrat support et la couche diélectrique d'oxyde de silicium peut créer des modes parasites dans les bandes de fréquence utilisées par les dispositifs à ondes acoustiques (SAWs).

Un but de l'invention est de remédier aux inconvénients précités et notamment de concevoir un substrat piézoélectrique sur isolant (POI) qui présente des meilleures caractéristiques pour une utilisation dans des dispositifs à ondes acoustiques (SAWs).

L'objet de l'invention est réalisé par substrat piézoélectrique sur isolant (POI) comprenant un substrat support ayant une première impédance acoustique, une couche piézoélectrique, en particulier une couche de Tantalate de Lithium (LTO), de Niobate de Lithium (LNO), de Nitrure d'Aluminium (AIN), de Titano-Circonate de Plomb (PZT), de Langasite ou de Langatate, une couche diélectrique ayant une deuxième impédance acoustique et positionnée en sandwich entre la couche piézoélectrique et le substrat support, une couche intermédiaire positionnée entre le substrat support et la couche diélectrique, caractérisé en ce que la couche intermédiaire est une couche avec une composition variable, en particulier le long de son épaisseur, de telle manière que l'impédance acoustique de la couche intermédiaire varie, en particulier de manière graduelle, entre les valeurs de la première et de la deuxième impédance acoustique. Ainsi, la variation de l'impédance acoustique de la couche intermédiaire permet de graduellement réduire la différence d'impédance acoustique entre la couche diélectrique et le substrat support dans un substrat piézoélectrique sur isolant (POI) et ainsi réduire les pertes de performance.

Selon un mode de réalisation, le substrat support peut être un substrat à base de silicium, la couche diélectrique est une couche d'oxyde de silicium et la couche intermédiaire est une couche d'oxynitrure de silicium SiOₓN_{y} ayant une composition variable d'oxygène et/ou une composition variable d'azote. L'utilisation d'une couche intermédiaire à base d'azote située entre la couche piézoélectrique et le substrat support permet de réduire la diffusion de Lithium ou d'Hydrogène dans le substrat support en même temps que de réaliser la couche intermédiaire avec une composition variable.

Selon un mode de réalisation, la variation de la composition d'oxygène et/ou de la composition d'azote de la couche intermédiaire est une variation graduelle linéaire ou par palier. La variation de la quantité qt de la couche d'oxynitrure de silicium permet de varier graduellement l'impédance acoustique de la couche intermédiaire. Selon un mode de réalisation, la composition variable de la couche intermédiaire d'oxynitrure de silicium SiOₓN_{y} est définie par la quantité qt= *y*/*(y+x)* et peut varier le long de son épaisseur, en particulier avec qt=0 à l'interface avec la couche diélectrique et au moins qt=0.4 à l'interface avec le substrat support. La variation de la quantité qt le long de l'épaisseur de la couche d'oxynitrure de silicium permet de réduire graduellement la différence d'impédance acoustique entre la couche diélectrique et le substrat support.

Selon un mode de réalisation s'intéressant aux ondes longitudinales, la quantité qt à l'interface avec le substrat support peut être égale à environ qt=0.5 car l'impédance acoustique Z est égale à 19.4*10⁶ Pa·s/m pour un substrat support de type Si (100), la quantité x peut être égale à environ qt=0.68 car Z=21.1*10⁶ Pa·s/m pour un substrat support de type Si (110) et la quantité qt peut être égale à environ qt=0.7 car Z=21.6*10⁶ Pa·s/m pour un substrat support de type Si (111). La variation de la quantité qt à l'interface avec le substrat support permet d'adapter l'impédance acoustique à l'impédance acoustique du substrat support en fonction de son orientation cristalline.

En fonction du mode de propagation d'intérêt pour le dispositif acoustique, c'est-à-dire soit pour une onde de propagation longitudinale, ou une onde de cisaillement lente appelée « slow shear » ou une onde de cisaillement rapide encore appelée « fast shear », d'autres valeurs optimisées peuvent être déterminées.

Selon un mode de réalisation, la quantité qt de la couche d'oxynitrure de silicium SiOₓN_{y} peut varier d'une manière croissante entre l'interface avec la couche diélectrique de la couche piézoélectrique et l'interface avec le substrat support, en particulier d'une manière croissante par palier ou linéaire. Ainsi, on peut encore plus réduire l'effet négatif des différence d'impédance acoustique.

Selon un mode de réalisation, le substrat piézoélectrique sur isolant (POI) peut comprendre en outre une couche de piégeage sur le substrat massif de support, en particulier une couche à base de silicium poly-cristallin. La présence d'une couche de piégeage sur le substrat support permet d'améliorer le substrat piézoélectrique sur isolant en réduisant la perte d'énergie dans le substrat support. La couche de piégeage étant à base de silicium, comme le substrat support, il est donc possible d'utiliser la couche intermédiaire en contact avec la couche de piégeage et de diminuer la différence d'impédance acoustique de la même manière que décrit précédemment.

L'objet de l'invention est aussi réalisé par un procédé de fabrication d'un substrat piézoélectrique sur isolant (POI) comprenant les étapes de fournir un substrat support ayant une première impédance acoustique, en particulier un substrat à base de silicium, fournir un substrat piézoélectrique, en particulier un substrat de Tantalate de Lithium (LTO), de Niobate de Lithium (LNO), de Nitrure d'Aluminium (AIN), de Titano-Circonate de Plomb (PZT), de Langasite ou de Langatate, former une couche diélectrique ayant une deuxième impédance acoustique sur le substrat piézoélectrique, en particulier une couche d'oxyde de silicium, former une couche intermédiaire sur une surface libre du substrat support, en particulier à base d'oxynitrure de silicium SiOₓN_{y}, la couche intermédiaire ayant une composition variable, en particulier le long de son épaisseur, de telle manière que l'impédance acoustique de la couche intermédiaire varie, en particulier de manière graduelle, entre les valeurs de la première et de la deuxième impédance acoustique, et assembler le substrat piézoélectrique avec la couche diélectrique avec le substrat support avec la couche intermédiaire. Ainsi, la variation de l'impédance acoustique de la couche intermédiaire permet de réduire graduellement la différence d'impédance acoustique entre la couche diélectrique et le substrat support dans le substrat piézoélectrique sur isolant et ainsi de réduire les pertes de performance du substrat piézoélectrique sur isolant (POI).

Selon un mode de réalisation, l'assemblage entre le substrat piézoélectrique et le substrat support peut être réalisé entre la couche intermédiaire et la couche diélectrique. La couche intermédiaire étant à base de SiOₓN_{y}, l'interface d'assemblage résulte en la formation de liaisons de type oxyde - oxyde, connues pour être stables.

Selon un mode de réalisation, le procédé peut comprendre en outre une étape de formation d'une couche diélectrique sur la couche intermédiaire du substrat support avant l'étape d'assemblage, de tel manière que l'assemblage est ensuite réalisé entre la couche diélectrique du substrat support et la couche diélectrique du substrat piézoélectrique. L'interface d'assemblage du substrat support avec la couche piézoélectrique est faite à l'interface entre deux couches diélectriques, avec des liaisons de type oxyde - oxyde, en particulier une liaison de type oxyde de silicium - oxyde de silicium, qui est une liaison stable.

Selon un mode de réalisation, l'étape de formation de la couche intermédiaire sur le substrat support peut comprendre la formation d'une couche à base d'oxynitrure de silicium SiOₓN_{y} dans laquelle la composition variable qt de la couche d'oxynitrure de silicium SiOₓN_{y} définie par la quantité qt₁= *y*/*(y+x)* varie le long de son épaisseur, en particulier avec qt₁ = 0 à l'interface avec la couche diélectrique et au moins qt₁ = 0.4 à l'interface avec le substrat support. Etant donné que l'impédance de la couche intermédiaire varie entre une valeur proche de la valeur de l'impédance de la couche diélectrique à l'interface avec la couche diélectrique et une valeur proche de la valeur de l'impédance du substrat support, la couche intermédiaire permet d'adapter les impédances acoustiques des différents matériaux du substrat piézoélectrique sur isolant (POI) obtenu par le procédé pour diminuer la différence d'impédance acoustique du substrat piézoélectrique sur isolant. Ainsi, le substrat piézoélectrique sur isolant (POI) obtenu présente une impédance acoustique mieux adaptée à son usage dans des dispositifs à ondes acoustiques, car elle résulte en une réduction d'effets parasites dans les bande de fréquence d'utilisation des dispositifs à ondes acoustiques.

Selon un mode de réalisation, l'étape de formation de la couche intermédiaire sur le substrat support peut comprendre la formation d'une couche à base d'oxynitrure de silicium SiOₓN_{y} dans laquelle la quantité qt₂ de la couche d'oxynitrure de silicium SiOₓN_{y} définie par qt₂= *y*/(*y+x*) varie le long de son épaisseur, en particulier avec au moins qt₂ = 0.4 à l'interface avec le substrat support, et le procédé peut comprendre en outre une étape de formation d'une couche SiOₓN_{y} sur la couche diélectrique du substrat piézoélectrique avant l'étape d'assemblage, ladite couche SiOₓN_{y} ayant une quantité qt₃ de la couche d'oxynitrure de silicium SiOₓN_{y} définie par qt₃= *y*/(*y+x*) variant le long de son épaisseur, en particulier qt₃ = 0 à l'interface avec la couche diélectrique du substrat piézoélectrique, de tel manière que l'assemblage est ensuite réalisé entre la couche SiOₓN_{y} du substrat support et la couche SiOₓN_{y} du substrat piézoélectrique avec qt₂ étant égal à qt₃ à l'interface entre les couches SiOₓN_{y} du substrat piézoélectrique et du substrat support.

L'interface d'assemblage du substrat support avec la couche piézoélectrique est faite à l'interface entre deux couches intermédiaires à base d'oxynitrure de silicium SiOₓN_{y}, avec des liaisons de type oxyde - oxyde permettant une liaison stable.

Selon un mode de réalisation, le procédé peut comprendre en outre une étape de formation d'une couche de piégeage sur le substrat support, en particulier une couche à base de silicium poly-cristallin. La présence d'une couche de piégeage sur le substrat support permet d'améliorer le substrat piézoélectrique sur isolant en réduisant la perte d'énergie dans le substrat support. La couche de piégeage étant à base de silicium, comme le substrat support, il est donc possible d'utiliser la couche intermédiaire en contact avec la couche de piégeage et de diminuer la différence d'impédance acoustique de la même manière que décrit précédemment.

Selon un mode de réalisation, l'étape de formation de la couche intermédiaire peut être réalisée par un dépôt pulvérisation par radiofréquence dans une atmosphère mixte d'oxygène et d'azote.

L'objet de l'invention est aussi réalisé par un dispositif à ondes acoustiques (SAW) comprenant un substrat piézoélectrique sur isolant comme décrit précédemment. Un tel dispositif SAW présente une réduction d'effets parasites dans les bandes de fréquence d'opération du dispositif grâce à l'adaptation de l'impédance acoustique entre le substrat support et la couche diélectrique du substrat piézoélectrique sur isolant (POI).

L'invention et ses avantages seront expliqués plus en détail dans la suite au moyen de modes de réalisation préférés et en s'appuyant notamment sur les figures d'accompagnement suivantes, dans lesquelles les numéros de référence identifient des caractéristiques de l'invention.
[Figure 1] représente schématiquement un substrat piézoélectrique sur isolant (POI) selon un premier mode de réalisation de l'invention.
[Figure 2] montre la variation de la vitesse de son de la couche intermédiaire en fonction de la quantité qt de la composition de la couche intermédiaire pour les valeurs de qt correspondant à qt=0, qt=0.33, qt=0.50, qt=0.68 et qt=1, selon le premier mode de réalisation de l'invention.
[Figure 3] représente la variation d'impédance acoustique de la couche intermédiaire en fonction de la quantité qt de la couche intermédiaire selon le premier mode de réalisation de l'invention.
[Figure 4] représente schématiquement un substrat piézoélectrique sur isolant (POI) selon une première variante du premier mode de réalisation de l'invention.
[Figure 5a] représente schématiquement un procédé de fabrication d'un substrat piézoélectrique sur isolant (POI) selon un deuxième mode de réalisation de l'invention.
[Figure 5b] représente schématiquement un procédé de fabrication d'un substrat piézoélectrique sur isolant (POI) selon une première variante du deuxième mode de réalisation de l'invention.
[Figure 5c] représente schématiquement un procédé de fabrication d'un substrat piézoélectrique sur isolant (POI) selon une deuxième variante du deuxième mode de réalisation de l'invention.

L'invention va être décrite plus en détail en utilisant des modes de réalisation avantageux d'une manière exemplaire et en référence aux dessins. Les modes de réalisation décrits sont simplement des configurations possibles et il faut garder à l'esprit que les caractéristiques individuelles telles que décrites ci-dessus peuvent être fournies indépendamment les unes des autres ou peuvent être omises tout à fait lors de la mise en œuvre de la présente invention.

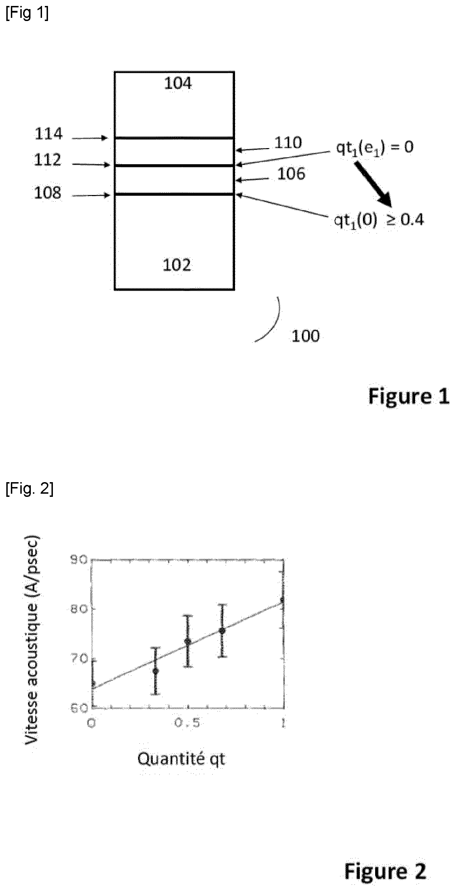

Figure 1 représente schématiquement un substrat piézoélectrique sur isolant (POI) selon un premier mode de réalisation de l'invention.

Le substrat piézoélectrique sur isolant (POI) 100 comprend un substrat support 102 assemblé à une couche piézoélectrique 104 via une couche intermédiaire 106 positionnée sur le substrat support 102 en contact direct avec le substrat support 102 à l'interface 108, et une couche diélectrique 110 à l'interface 112. La couche diélectrique 110 est en contact direct avec la couche piézoélectrique 104 à l'interface 114.

Le substrat support 102 peut être un substrat à base de silicium, en particulier un substrat massif à base de silicium. Le substrat support 102 peut être un substrat cristallin ou poly-cristallin. Le substrat support 102 à base de silicium cristallin peut avoir une orientation (111), une orientation (100) ou encore une orientation (110). Le silicium (100) a une impédance acoustique Z égale à 19.4*10⁶ Pa·s/m, Le silicium (111) a une impédance acoustique de Z=21.6*10⁶ Pa·s/m, le silicium (110) a une impédance acoustique de Z=21.1*10⁶ Pa·s/m.

Selon l'invention, la couche diélectrique 110 est une couche à base d'oxyde de silicium avec une épaisseur entre 100 et 900nm, en particulier entre 200 et 700nm. La couche diélectrique 110 a une deuxième impédance acoustique qui est différente de la première impédance acoustique du substrat support 102, car l'oxyde de silicium a une impédance acoustique comprise entre 11.5*10⁶ Pa·s/m et 14*10⁶ Pa·s/m, en particulier environ 13.7*10⁶ Pa·s/m. Dans une variante, la couche diélectrique 110 peut aussi être une couche à base de nitrure de silicium ou une couche comprenant une combinaison de nitrure et d'oxyde de silicium SiOₓN_{y} avec une quantité de nitrure constante dans la couche.

La couche piézoélectrique 104 est une couche à base de matériau piézoélectrique avec une épaisseur comprise entre 200nm et 700nm. Le matériau piézoélectrique peut, par exemple, être du Tantalate de Lithium (LTO), du Niobate de Lithium (LNO), du Nitrure d'Aluminium (AIN), du Titano-Circonate de Plomb (PZT), de la Langasite ou du Langatate.

La couche intermédiaire 106 est une couche ayant une composition variable, en particulier le long de son épaisseur *e₁*. La variation de la composition de la couche intermédiaire 106 est telle que l'impédance acoustique de la couche intermédiaire 106 varie entre les valeurs de la première et de la deuxième impédance acoustique du substrat support 102 et de la couche diélectrique 110 respectivement. L'impédance acoustique variable de la couche intermédiaire 106 permet de limiter l'impact de la différence d'impédance acoustique entre la couche diélectrique 110 et le substrat support 102 du substrat POI 100 en passant graduellement de la valeur de la première impédance à la valeur de la deuxième impédance.

Selon une réalisation de l'invention, la couche intermédiaire 106 est une couche à base d'oxynitrure de silicium SiOₓN_{y}. L'épaisseur *e₁* de la couche intermédiaire 106 est comprise entre 100nm et 1000nm, en particulier entre 200nm et 1000nm.

La couche intermédiaire 106 d'oxynitrure de silicium SiOₓN_{y} selon l'invention présente une stœchiométrie qui varie en fonction de son épaisseur *e₁* pour adapter ainsi son impédance acoustique. En effet, l'impédance acoustique de la couche dépend de la variation de la quantité d'oxygène et/ou de la variation de la quantité d'azote dans la couche.

Les valeurs de x et y sont choisies de sorte qu'une variation désirée ou prédéterminée de l'impédance acoustique est observée. La quantité d'oxygène et d'azote dans la couche intermédiaire 106 dépendent du procédé de fabrication utilisé pour déposer la couche de SiOₓN_{y}.

Selon un mode de réalisation, la couche intermédiaire est réalisée telle que décrit dans Grahn et al : « Elastic properties of silicon oxynitride films determined by picosecond acoustics », Applied Physics Letter 53, 2281,1988 pour obtenir une stœchiométrie de la couche intermédiaire 106 d'oxynitrure de silicium SiOₓN_{y} qui varie selon qt₁(*e₁*) = *y*/*(y+x).* La couche de SiOₓN_{y} est réalisée par dépôt par pulvérisation par radiofréquence (en Anglais : rf sputtering) dans une atmosphère mixte d'oxygène et d'azote. Ainsi, la composition de la couche SiOₓN_{y} est contrôlée en variant le rapport *y*/*(y+x)* qui correspond à la quantité d'azote et la quantité d'azote et d'oxygène dans l'atmosphère lors du dépôt.

La variation de la quantité qt de la couche d'oxynitrure de silicium SiOₓN_{y} 106 est une variation dans l'épaisseur *e₁* de la couche 106, entre les deux surfaces de la couche intermédiaire 106. Dans ce premier mode de réalisation, la variation de la quantité qt₁ de la couche d'oxynitrure de silicium SiOₓN_{y} 106 est une variation croissante entre l'interface 112 avec la couche diélectrique 110 et l'interface 108 avec le substrat support 102. La variation est par exemple croissante par palier ou est une croissance linéaire.

La Figure 2 montre la variation de la vitesse de l'onde acoustique longitudinale V_{longi}dans la couche intermédiaire 106 en fonction de la quantité qt d'azote (N) dans la couche intermédiaire 106 pour les valeurs de la quantité qt de la couche intermédiaire 106 de 0, 0.33, 0.50, 0.68 et 1. Cette figure a été publiée dans Grahn et al : « Elastic properties of silicon oxynitride films determined by picosecond acoustics », Applied Physics Letter 53, 2281,1988.

De même, une augmentation linéaire de la vitesse de l'onde acoustique longitudinale en fonction d'une augmentation de la quantité qt de la couche intermédiaire 106 est visible. La ligne représentant la variation linéaire est un ajustement par la méthode des moindres carrés aux points de données.

En partant des données de la Figure 2, l'impédance acoustique est obtenu en calculant l'impédance acoustique Z avec Z = V_{longi} * density, avec V_{longi} étant la vitesse de l'onde acoustique longitudinale, selon Grahn et al : « Elastic properties of silicon oxynitride films determined by picosecond acoustics », Applied Physics Letter 53, 2281 (1988).

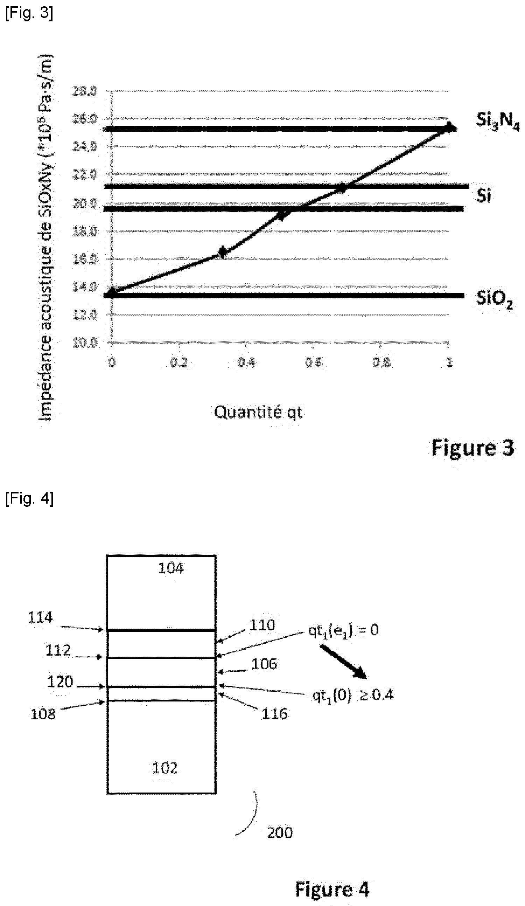

La variation de l'impédance acoustique de la couche de SiOₓN_{y} en fonction de la quantité qt est illustrée à la Figure 3. Pour une quantité qt égale à 0, la valeur de l'impédance acoustique Z est égale à la valeur de l'impédance acoustique Z d'une couche d'oxyde de silicium, étant de l'ordre de 13.7*10⁶ Pa·s/m. Lorsque la quantité qt augmente, l'impédance acoustique de la couche intermédiaire 106 augmente continuellement. Pour une valeur de quantité qt entre 0.5 et 0.7, l'impédance acoustique Z devient comparable à l'impédance acoustique Z du silicium qui est entre 19.4 *10⁶ Pa·s/m et 21.8 *10⁶ Pa·s/m, en fonction de l'orientation cristalline du silicium. Pour qt=1, on obtient l'impédance acoustique Z de Si₃N₄, qui est de l'ordre de 25.5 *10⁶ Pa·s/m. Cependant, cette valeur de l'impédance acoustique Z dépend des techniques de dépôts utilisées.

Ainsi, en variant la quantité qt₁ de la couche intermédiaire 106, une variation de la valeur de l'impédance acoustique de la couche 106 peut être obtenue, valeur qui peut varier entre la valeur de l'impédance acoustique d'une couche de Si₃N₄ et d'une couche d'oxyde de silicium. En partant des valeurs enseignées dans la Figure 3, il est possible de choisir la valeur de quantité qt en fonction de la position dans l'épaisseur *e₁* de la couche de SiOₓN_{y}.

Sur la base des renseignements de la figure 3, on choisit qt₁(*e₁*) = 0 dans la couche intermédiaire 106 à l'interface 112 avec la couche diélectrique 110. Ensuite qt₁ croît en fonction de l'épaisseur *e₁* jusqu'à arriver à une quantité qt₁(*e₁*=0) ≥ 0.4, en particulier qt₁(*e₁*=0) = 0.7 à l'interface avec le substrat support. Ainsi, l'impédance acoustique de la couche intermédiaire 106 à l'interface 108 avec le substrat support 102 (*e₁* = 0) est de l'ordre de la première impédance acoustique du substrat support 102.

La couche intermédiaire 106 permet ainsi de réduire la différence d'impédance acoustique entre le substrat support 102 et la couche diélectrique d'oxyde de silicium 110 par son impédance acoustique qui est comprise entre l'impédance du substrat support 102 et celle de la couche diélectrique 110.

De plus, l'interface 112 entre la couche diélectrique 110 et la couche intermédiaire 106 est une interface sans azote (N) et qui comporte des liaisons oxyde de silicium - oxyde de silicium, qui sont connues pour être des liaisons stables qui améliore l'adhésion.

De plus, étant donné que la couche intermédiaire 106 est une couche à base de SiOₓN_{y}, la présence d'azote dans la couche intermédiaire 106 permet de réduire la diffusion de Lithium ou d'Hydrogène dans le substrat support 102.

Ainsi, le substrat piézoélectrique sur isolant (POI) 100 selon l'invention présente une stabilité améliorée ainsi que des caractéristiques améliorées pour son usage dans des dispositifs à ondes de surfaces (SAWs) tels que des capteurs, filtres ou autres. La réduction de la différence d'impédance acoustique dans le substrat piézoélectrique sur isolant (POI) 100 résulte en une réduction de modes indésirables dans les plages de fréquences voulues de fonctionnement de dispositifs à ondes de surfaces (SAWs).

La figure 4 montre une variante du premier mode de réalisation de l'invention. La seule différence entre le substrat POI 100 et le substrat POI 200 de la variante est la présence d'une couche de piégeage 116 entre le substrat support 102 et la couche intermédiaire 106. Toutes les autres caractéristiques du substrat POI sont les mêmes que celles décrites à la Figure 1. Toutes les caractéristiques communes avec le premier mode de réalisation utilisant le même numéro de référence que ci-dessus ne seront pas décrites à nouveau, mais il est fait référence à leur description détaillée ci-dessus.

La couche de piégeage 116 est en contact avec le substrat support 102 à l'interface 118 et est aussi en contact avec la couche intermédiaire 106 à l'interface 120. La couche de piégeage 116 est en sandwich entre le substrat support 102 et la couche intermédiaire 106.

La couche de piégeage 116 est une couche à base de silicium poly-cristallin ou amorphe ou poreux, ayant une épaisseur comprise entre 200nm et 5µm, en particulier entre 500nm et 2µm. La couche de piégeage 116 a une troisième impédance acoustique d'une valeur d'environ 21*10⁶ Pa·s/m, cette valeur étant proche de la moyenne des valeurs de l'acoustique impédance pour les trois orientations du silicium possibles citées auparavant.

**Dans** cette variante, la valeur de la quantité qt₁ de la composition variable de la couche d'oxynitrure de silicium SiOₓN_{y} 106 varie de telle manière que l'impédance acoustique de la couche intermédiaire 106 à l'interface 120 avec la couche de piégeage 116 est de l'ordre de la troisième impédance acoustique de la couche de piégeage 116.

Le substrat piézoélectrique sur isolant (POI) 200 présente les mêmes avantages que le substrat piézoélectrique sur isolant (POI) 100 décrit à la figure 1.

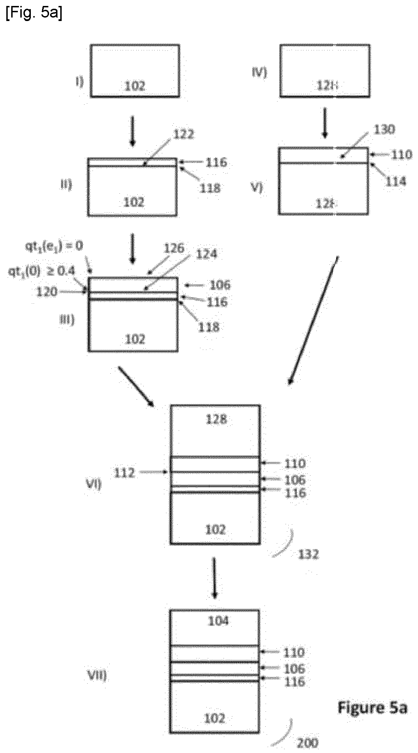

Figure 5a représente schématiquement un procédé de fabrication d'un substrat piézoélectrique sur isolant (POI) selon un deuxième mode de réalisation de l'invention pour obtenir un substrat POI tel que décrit ci-dessus aux Figures 1 et 4 selon le premier mode de réalisation de l'invention. Des éléments avec les mêmes numéros de références ainsi que leurs propriétés ne seront pas décrits à nouveau mais référence est faite à leur description ci-dessus.

Le procédé de fabrication d'un substrat piézoélectrique sur isolant (POI) 200 commence par l'étape I) de fournir un substrat support 102, notamment un substrat à base de silicium, en particulier un substrat de silicium cristallin ou poly-cristallin.

Selon l'invention, l'étape II) consiste en la formation de la couche de piégeage 116 sur la surface libre 122 du substrat support 102. La formation de la couche de piégeage 116 peut être réalisée par une technique de croissance thermique ou assisté par plasma telle que PECVD (acronyme de l'expression anglaise « Plasma Enhanced Chemical Vapor Deposition », en français « technique de dépôt chimique en phase vapeur activé par plasma ») ou PVD (acronyme de l'expression anglaise « Physical Vapor Deposition », en français « technique de dépôt physique en phase vapeur »).

La couche de piégeage 116 formée sur le substrat support 102 est une couche à base de silicium, en particulier du silicium poly-cristallin. L'épaisseur de la couche de piégeage 116 est comprise entre 200nm et 5µm, en particulier entre 500nm et 2µm. La couche de piégeage 116 a une quatrième impédance acoustique, qui peut être la même que celle du substrat support 102 ou bien une autre.

Lors de l'étape III) la couche intermédiaire 106 est formée sur la surface libre 124 de la couche de piégeage 116.

La formation de la couche intermédiaire 106 peut être réalisée par une technique de croissance thermique ou assisté par plasma telle que LPCVD (acronyme de l'expression anglaise « Low Pressure Chemical Vapor Deposition », en français « dépôt chimique en phase vapeur à basse pression ») ou PECVD (en français « technique de dépôt chimique en phase vapeur activé par plasma »).

La couche intermédiaire 106 est une couche à base d'oxynitrure de silicium SiOₓN_{y}. L'épaisseur de la couche intermédiaire 106 est comprise entre 100nm et 1000nm, en particulier entre 200nm et 1000nm.

Pour obtenir la composition variable de la couche intermédiaire 106, les paramètres de déposition sont variés lors du dépôt pour modifier la quantité d'azote et/ou la quantité d'oxygène dans l'épaisseur de la couche déposée, de telle manière que la variation graduelle de la composition de la couche déposée 106 est obtenue pour obtenir l'impédance acoustique désirée à la surface supérieure libre 126 de la couche déposée 106, comme expliqué auparavant.

La variation de la composition de la couche d'oxynitrure de silicium SiOₓN_{y} déposée est définie par qt= *y*/*(y+x).*

La variation de la quantité qt₁ est une variation décroissante entre l'interface 108 avec le substrat support 102 et la surface libre supérieure 126 de la couche d'oxynitrure de silicium SiOₓN_{y} 106. La variation est décroissante par palier ou est une décroissance linéaire.

A l'interface 118 avec le substrat support 102, la quantité qt₁ est au moins égale à 0.4, en particulier la quantité qt₁ est de l'ordre de 0.7. Ainsi, l'impédance acoustique de la couche intermédiaire 106 à l'interface 118 avec le substrat support 102 est de l'ordre de la première impédance acoustique du substrat support 102, en particulier elle est la même.

A la surface libre 126 de la couche intermédiaire 106, qui est prévue pour entrer en contact avec une autre couche lors d'une étape de procédé ultérieure, la quantité qt₁ est définie par la valeur d'impédance acoustique de la couche qui va être mise en contact sur la surface libre 126.

Lors de l'étape IV) le substrat piézoélectrique 128 est fourni.

Lors de l'étape V) la couche diélectrique 110 est réalisée sur la surface libre 130 du substrat piézoélectrique 128. Avant de réaliser la formation de la couche diélectrique 110, une ou plusieurs étapes de nettoyage, de brossage ou de polissage de la surface 130 du substrat piézoélectrique 128 peut / peuvent être réalisées pour enlever la présence de particules et de poussière pour obtenir ainsi une surface libre 130 plus propre ce qui permet l'obtention d'une couche diélectrique 110 déposée de meilleure qualité.

La formation de la couche diélectrique 110 sur la surface libre 130 du substrat piézoélectrique 128 peut être réalisée par une technique de croissance thermique ou assisté par plasma telle que LPECVD à basse pression et/ou à basse température. Un traitement thermique peut être réalisé après le dépôt de la couche diélectrique 110 pour densifier la couche diélectrique 110.

Selon une variante, des étapes de traitement de surface de la surface libre 130 du substrat piézoélectrique 128 peuvent être réalisées avant la formation de la couche diélectrique 110. Par exemple, un traitement d'activation de surface comme un traitement plasma ou un traitement à base d'ozone.

Selon l'invention, la couche diélectrique 110 est une couche d'oxyde de silicium.

Selon l'invention, le substrat piézoélectrique 128 obtenu après l'étape V), est ensuite assemblé au substrat support 102 obtenu à l'étape III) durant une étape VI) d'assemblage pour former un assemblage 132 substrat support - substrat piézoélectrique. L'assemblage du substrat piézoélectrique 128 sur le substrat support 102 est fait telle que la couche intermédiaire 106 est positionnée en contact avec la couche diélectrique 110 du substrat piézoélectrique 128 de telle manière que la couche intermédiaire 106 est en sandwich entre la couche diélectrique 110 du substrat piézoélectrique 128 et le substrat support 102. La couche intermédiaire 106 est ainsi en contact direct avec la couche diélectrique 110 du substrat piézoélectrique 128 à l'interface 112.

Dans cette structure, l'impédance acoustique de la couche intermédiaire 106 à la surface libre 126 est de l'ordre de l'impédance acoustique de la couche diélectrique d'oxyde de silicium 110. De plus, le collage entre les substrats se fait à une interface 112 qui est essentiellement faite du même matériau des deux côtés de l'interface 112.

Une fois les deux substrats assemblés, une étape d'amincissement VII) (non illustrées) du substrat piézoélectrique 128 peut être réalisée pour obtenir une couche plus mince piézoélectrique 104. Par exemple, l'étape d'amincissement peut être réalisée par meulage ou par une étape de formation d'une zone de fragilisation dans le substrat piézoélectrique 128 de manière à délimiter la couche piézoélectrique 104 à transférer sur le substrat support 102 et fracturation. Cette étape de formation d'une zone de fragilisation est réalisée par une implantation d'espèces atomiques ou ioniques dans le substrat piézoélectrique 128. L'implantation atomique ou ionique peut être réalisée de telle manière que la zone de fragilisation est située à l'intérieure du substrat piézoélectrique 128 et sépare une couche piézoélectrique 104 du reste du substrat piézoélectrique 128.

Ensuite, une étape de fracturation de l'assemblage 132 substrat support - substrat piézoélectrique par apport d'énergie thermique et/ou mécanique au niveau de la zone de fragilisation du substrat piézoélectrique 128 est ensuite réalisée pour obtenir un substrat piézoélectrique sur isolant (POI) 200 comme illustré à l'étape VII) de la Figure 5a et sur la Figure 4, comprenant une couche piézoélectrique 104 plus mince sur un substrat support 102.

Cette méthode peut aussi être appliquée pour obtenir le substrat de la Figure 1.

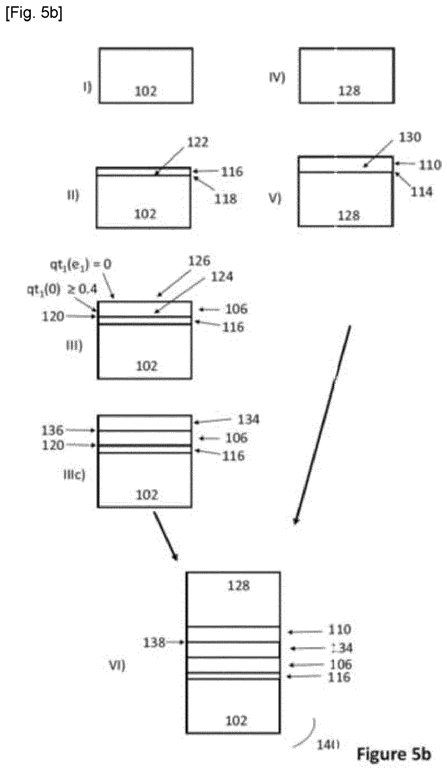

Figure 5b représente schématiquement un procédé de fabrication d'un substrat piézoélectrique sur isolant (POI) selon une première variante du deuxième mode de réalisation de l'invention.

Toutes les caractéristiques communes avec le deuxième mode de réalisation utilisant le même numéro de référence que ci-dessus ne seront pas décrites à nouveau, mais il est fait référence à leur description détaillée ci-dessus.

La seule différence entre ce procédé et celui de la Figure 5a consiste en la formation IIIc) d'une couche diélectrique 134 sur la surface libre de la couche intermédiaire 106 après l'étape III) de la Figure 5a. La couche diélectrique 134 est du même matériau que la couche diélectrique 110, donc en oxyde de silicium. La couche diélectrique 134 peut être réalisée de la même manière que la couche diélectrique 110.

Ainsi, lors de l'étape d'assemblage VI), la couche diélectrique 134 est mise en contact avec la couche diélectrique 110 du substrat piézoélectrique 128 à l'interface 138. L'assemblage 140 se fait donc par adhésion moléculaire entre les deux couches diélectriques 110, 134 qui sont du même matériau, ici l'oxyde de silicium. Ainsi le collage entre les substrats 102, 128 est amélioré.

Toutes les autres étapes du procédé de cette variante sont les mêmes que les étapes pour le procédé selon le deuxième mode de réalisation décrites pour la Figure 5a, pour obtenir le substrat (POI) 200.

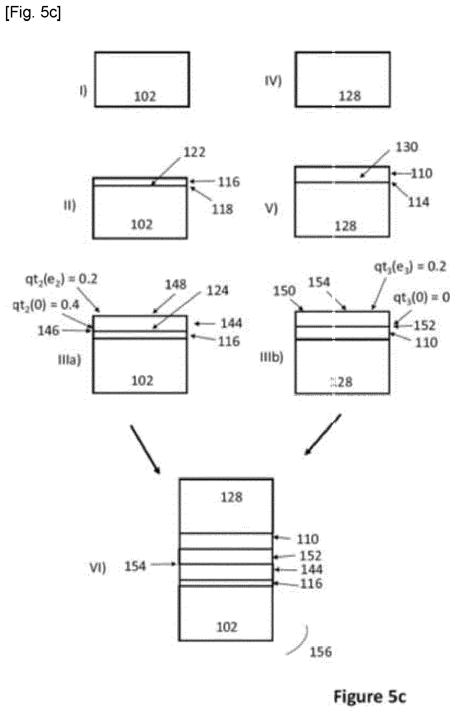

Figure 5c représente schématiquement un procédé de fabrication d'un substrat piézoélectrique sur isolant (POI) selon une deuxième variante du deuxième mode de réalisation de l'invention.

Toutes les caractéristiques communes avec le deuxième mode de réalisation et ses variantes utilisant le même numéro de référence que ci-dessus ne seront pas décrites à nouveau, mais il est fait référence à leur description détaillée ci-dessus.

La seule différence entre ce procédé est celui de la Figure 5a consiste en la séparation de la couche intermédiaire 106 en deux parties. L'étape III) de la Figure 5a est remplacée par deux étapes IIIa) et IIIb). Une première couche intermédiaire 144 est formée sur la couche riche en piège 116 lors de l'étape IIIa). Une deuxième couche intermédiaire 150 est réalisée sur la couche diélectrique 110 lors de l'étape IIIb).

Pour la première couche intermédiaire 144 formée sur le substrat support 102 et donc sur la couche riche en piège 116, la première couche 144 est déposée de telle manière lors de l'étape IIIa) que la quantité qt₂ de la composition variable de la première couche d'oxynitrure de silicium SiOₓN_{y} 144 varie le long de son épaisseur avec au moins qt₂(0) = 0.4 à l'interface 146 avec la couche riche en piège 116 du substrat support 102.

La première couche 144 est déposée telle que la quantité qt₂ de la première couche d'oxynitrure de silicium SiOₓN_{y} 144 varie de manière décroissante le long de l'épaisseur de la première couche intermédiaire 144.

A la surface libre 148 de la première couche intermédiaire 144 la quantité qt₂ est choisie pour être la même que celle de la couche qui va être mise en contact lors de l'étape VII). Ici par exemple qt₂(*e₂*) = 0.2.

Pour la deuxième couche intermédiaire 150 formée sur le substrat piézoélectrique 128, la deuxième couche 150 est déposée de telle manière lors de l'étape IIIb) que la quantité qt₃ de la composition variable de la deuxième couche d'oxynitrure de silicium SiOₓN_{y} 150 varie le long de son épaisseur avec qt₃ (*e₃*=0) = 0 à son interface 152 avec la couche diélectrique 110.

La deuxième couche 150 est déposée telle que la quantité qt₃ de la deuxième couche d'oxynitrure de silicium SiOₓN_{y} 150 varie de manière croissante le long de l'épaisseur *e₃* de la couche intermédiaire 150.

A la surface libre 154 de la deuxième couche intermédiaire 150, la quantité qt₃ est la même que la quantité qt₂ à la surface libre 148 de la première couche intermédiaire 144. Ici donc qt₃(*e₃*) = 0.2.

Ainsi, lors de l'étape d'assemblage VI), la première couche intermédiaire 144 du substrat support 102 est mise en contact avec la deuxième couche intermédiaire 150 du substrat piézoélectrique 128

Comme dans les autres procédés décrits par rapport aux figures 5a et 5b, l'impédance acoustique varie à travers la première et la deuxième couche intermédiaire 144 et 150 entre la valeur de la couche riche en piège 116 et la valeur de la couche diélectrique 110.

L'assemblage 156 se fait par adhésion moléculaire entre les deux substrats 102, 128, à l'interface 158 entre la première couche intermédiaire 144 et la deuxième couche intermédiaire 150. L'assemblage 156 se fait donc par adhésion moléculaire entre les deux couches intermédiaires 144, 150 qui ont essentiellement le même matériau à l'interface, ici la couche d'oxynitrure de silicium SiOₓN_{y} avec qt=0.2. Ainsi, le collage entre les substrats 102, 128 est amélioré.

Toutes les autres étapes du procédé de cette variante sont les mêmes que les étapes pour le procédé selon le deuxième mode de réalisation décrites pour la Figure 5a, pour obtenir le substrat (POI) 200.

Le procédé selon le deuxième mode de réalisation peut aussi être utilise pour fabriquer le substrat piézoélectrique sur isolant (POI) 100 selon la Figure 1 sans la présence d'une couche riche en piège 116 sur le substrat support 102.

Les modes de réalisation décrits sont simplement des configurations possibles et il faut garder à l'esprit que les caractéristiques individuelles des différents modes de réalisation peuvent être combinées entre elles ou fournies indépendamment les unes des autres.

## Revendications

1. Substrat piézoélectrique sur isolant, POI, (100, 200) comprenant:
- un substrat support (102) ayant une première impédance acoustique,
- une couche piézoélectrique (104), en particulier une couche de Tantalate de Lithium, LTO, de Niobate de Lithium, LNO, de Nitrure d'Aluminium, AIN, de Titano-Circonate de Plomb, PZT, de Langasite ou de Langatate,
- une couche diélectrique (110) ayant une deuxième impédance acoustique et positionnée en sandwich entre la couche piézoélectrique (104) et le substrat support (102),
- une couche intermédiaire (106) positionnée entre le substrat support (102) et la couche diélectrique (110),
**caractérisé en ce que**
la couche intermédiaire (106) est une couche avec une composition variable, en particulier le long de son épaisseur, de telle manière que l'impédance acoustique de la couche intermédiaire (106) varie, en particulier de manière graduelle, entre les valeurs de la première et de la deuxième impédance acoustique.

2. Substrat POI (100, 200) selon la revendication 1, dans lequel le substrat support (102) est un substrat à base de silicium, la couche diélectrique (110) est une couche d'oxyde de silicium et la couche intermédiaire (106) est une couche d'oxynitrure de silicium SiOₓN_{y} ayant une composition variable d'oxygène et/ou une composition variable d'azote.

3. Substrat POI (100, 200) selon la revendication 1 ou 2, dans lequel la variation de la composition de la couche intermédiaire (106) est une variation graduelle linéaire ou par palier.

4. Substrat POI (100, 200) selon une des revendications 1 à 3, dans lequel la composition variable de la couche intermédiaire (106) de la quantité qt de la composition variable de la couche d'oxynitrure de silicium SiOₓN_{y} (106) est définie par qt= y/(y+x) et varie le long de son épaisseur, en particulier avec qt = 0 à l'interface (112) avec la couche diélectrique (110) et au moins qt = 0.4 à l'interface (108) avec le substrat support (102).

5. Substrat POI (100, 200) selon la revendication 4, dans lequel la quantité qt à l'interface (108) avec le substrat support (102) est égale à environ 0.5 pour un substrat support (102) de type Si avec une orientation (100), qt est égale à environ 0.68 pour un substrat support (102) de type Si avec une orientation (110) et qt est égale à environ 0.7 pour un substrat support (102) de type Si avec une orientation (111).

6. Substrat POI (100, 200) selon la revendication 4 ou 5, dans lequel la quantité qt de la couche d'oxynitrure de silicium SiOₓN_{y} (106) varie d'une manière croissante entre l'interface (112) avec la couche diélectrique (110) de la couche piézoélectrique (104) et l'interface (108) avec le substrat support (102), en particulier d'une manière croissante par palier ou linéaire.

7. Substrat POI (100, 200) selon une des revendications 1 à 6, comprenant en outre une couche de piégeage (116) sur le substrat de support (102), en particulier une couche à base de silicium poly-cristallin.

8. Procédé de fabrication d'un substrat POI selon une des revendications 1 à 7 comprenant les étapes de:
- fournir un substrat support (102) ayant une première impédance acoustique, en particulier un substrat à base de silicium,
- fournir un substrat piézoélectrique (128), en particulier un substrat de Tantalate de Lithium, LTO, de Niobate de Lithium, LNO, de Nitrure d'Aluminium, AIN, de Titano-Circonate de Plomb, PZT, de Langasite ou de Langatate,
- former une couche diélectrique (110) ayant une deuxième impédance acoustique sur le substrat piézoélectrique, en particulier une couche d'oxyde de silicium,
- former une couche intermédiaire (106) sur une surface libre du substrat support, en particulier à base d'oxynitrure de silicium SiOₓN_{y}, la couche intermédiaire ayant une composition variable, en particulier le long de son épaisseur e, de telle manière que l'impédance acoustique de la couche intermédiaire varie, en particulier de manière graduelle, entre les valeurs de la première et de la deuxième impédance acoustique, et
- assembler le substrat piézoélectrique avec la couche diélectrique avec le substrat support avec la couche intermédiaire.

9. Procédé de fabrication d'un substrat POI selon la revendication 8, dans lequel l'assemblage entre le substrat piézoélectrique et le substrat support est réalisé entre la couche intermédiaire et la couche diélectrique.

10. Procédé de fabrication d'un substrat POI selon la revendication 8, comprenant en outre une étape de formation d'une couche diélectrique (134) sur la couche intermédiaire (106) du substrat support (102) avant l'étape d'assemblage, de tel manière que l'assemblage est ensuite réalisé entre la couche diélectrique (134) du substrat support et la couche diélectrique (110) du substrat piézoélectrique.

11. Procédé de fabrication d'un substrat POI selon une des revendications 8 à 10, dans lequel l'étape de formation de la couche intermédiaire sur le substrat support comprend la formation d'une couche à base d'oxynitrure de silicium SiOₓN_{y} dans laquelle la quantité d'azote par rapport à l'oxygène dans la couche d'oxynitrure de silicium SiOₓN_{y} définie par qt₁= *y*/(*y+x*) varie le long de son épaisseur *e₁*, en particulier avec qt₁ = 0 à l'interface avec la couche diélectrique et au moins qt₁ = 0.4 à l'interface avec le substrat support.

12. Procédé de fabrication d'un substrat POI selon la revendication 8, dans lequel l'étape de formation de la couche intermédiaire sur le substrat support comprend la formation d'une couche à base d'oxynitrure de silicium SiOₓN_{y} (144)
dans laquelle la quantité qt₂ de la couche d'oxynitrure de silicium SiOₓN_{y} définie par qt₂= *y*/(*y+x*) varie le long de son épaisseur *e₂*, en particulier avec au moins qt₂ = 0.4 à l'interface avec le substrat support, et
le procédé comprend en outre une étape de formation d'une couche SiOₓN_{y} (150) sur la couche diélectrique (110) du substrat piézoélectrique (128) avant l'étape d'assemblage, ladite couche SiOₓN_{y} ayant une quantité qt₃ de la couche d'oxynitrure de silicium SiOₓN_{y} définie par qt₃= *y*/*(y+x)* variant le long de son épaisseur *e₃*, en particulier qt₃ = 0 à l'interface avec la couche diélectrique du substrat piézoélectrique,
de tel manière que l'assemblage est ensuite réalisé entre la couche SiOₓN_{y} (144) du substrat support et la couche SiOₓN_{y} (150) du substrat piézoélectrique avec qt₂ étant égal à qt₃ à l'interface entre les couches SiOₓN_{y} du substrat piézoélectrique et du substrat support.

13. Procédé de fabrication d'un substrat POI selon une des revendications 8 à 12, comprenant en outre une étape de formation d'une couche de piégeage (116) sur le substrat support (102), en particulier une couche à base de silicium poly-cristallin.

14. Procédé de fabrication d'un substrat POI selon une des revendications 8 à 13, dans lequel l'étape de formation de la couche intermédiaire est réalisée par un dépôt pulvérisation par radiofréquence dans une atmosphère mixte d'oxygène et d'azote.

15. Dispositif à ondes acoustiques de surface, SAW, comprenant un substrat POI (100, 200) selon une des revendications 1 à 7.

## Patentansprüche

1. Piezoelektrikum-auf-Isolator-, POI-, Substrat (100, 200), umfassend:
- ein Trägersubstrat (102) mit einer ersten akustischen Impedanz,
- eine piezoelektrische Schicht (104), insbesondere eine Schicht aus Lithiumtantalat, LTO, Lithiumniobat, LNO, Aluminiumnitrid, AIN, Blei-Titan-Circonat, PZT, Langasit oder Langatat,
- eine dielektrische Schicht (110), die eine zweite akustische Impedanz aufweist und, die als Sandwich zwischen der piezoelektrischen Schicht (104) und dem Trägersubstrat (102) positioniert ist,
- eine Zwischenschicht (106), die zwischen dem Trägersubstrat (102) und der dielektrischen Schicht (110) positioniert ist,
**dadurch gekennzeichnet, dass**
die Zwischenschicht (106) eine Schicht mit einer variablen Zusammensetzung ist, insbesondere entlang ihrer Dicke, so, dass die akustische Impedanz der Zwischenschicht (106), insbesondere allmählich, zwischen den Werten der ersten und der zweiten akustischen Impedanz variiert.

2. POI-Substrat (100, 200) nach Anspruch 1, wobei das Trägersubstrat (102) ein Substrat auf Siliziumbasis ist, die dielektrische Schicht (110) eine Siliziumoxidschicht ist und die Zwischenschicht (106) eine Siliziumoxynitridschicht SiOₓN_{y} ist, die eine variable Sauerstoffzusammensetzung und/oder eine variable Stickstoffzusammensetzung aufweist.

3. POI-Substrat (100, 200) nach Anspruch 1 oder 2, wobei die Änderung der Zusammensetzung der Zwischenschicht (106) eine lineare oder stufenweise allmähliche Änderung ist.

4. POI-Substrat (100, 200) nach einem der Ansprüche 1 bis 3, wobei die variable Zusammensetzung der Zwischenschicht (106) der Menge qt der variablen Zusammensetzung der Siliziumoxynitridschicht SiOₓN_{y} (106) durch qt= y/(y+x) definiert ist und entlang ihrer Dicke variiert, insbesondere mit qt = 0 an der Schnittstelle (112) mit der dielektrischen Schicht (110) und mindestens qt = 0,4 an der Schnittstelle (108) mit dem Trägersubstrat (102).

5. POI-Substrat (100, 200) nach Anspruch 4, wobei die Menge qt an der Schnittstelle (108) mit dem Trägersubstrat (102) etwa 0,5 für ein Trägersubstrat (102) von dem Typ Si mit einer Ausrichtung (100) entspricht, qt etwa 0,68 für ein Trägersubstrat (102) von dem Typ Si mit einer Ausrichtung (110) entspricht und qt etwa 0,7 für ein Trägersubstrat (102) von dem Typ Si mit einer Ausrichtung (111) entspricht.

6. POI-Substrat (100, 200) nach Anspruch 4 oder 5, wobei die Menge qt der Siliziumoxynitridschicht SiOₓN_{y} (106) zwischen der Schnittstelle (112) mit der dielektrischen Schicht (110) der piezoelektrischen Schicht (104) und der Schnittstelle (108) mit dem Trägersubstrat (102) zunehmend variiert, insbesondere stufenweise oder linear zunehmend.

7. POI-Substrat (100, 200) nach einem der Ansprüche 1 bis 6, ferner umfassend eine Einschlussschicht (116) auf dem Trägersubstrat (102), insbesondere eine Schicht auf Basis von polykristallinem Silizium.

8. Verfahren zur Herstellung eines POI-Substrats nach einem der Ansprüche 1 bis 7, umfassend die folgenden Schritte:
- Bereitstellen eines Trägersubstrats (102), das eine erste akustische Impedanz aufweist, insbesondere eines Substrats auf Siliziumbasis,
- Bereitstellen eines piezoelektrischen Substrats (128), insbesondere eines Substrats aus Lithiumtantalat, LTO, Lithiumniobat, LNO, Aluminiumnitrid, AIN, Blei-Zirkonat-Titanat, PZT, Langasit oder Langatat,
- Bilden einer dielektrischen Schicht (110) mit einer zweiten akustischen Impedanz auf dem piezoelektrischen Substrat, insbesondere einer Siliziumoxidschicht,
- Bilden einer Zwischenschicht (106) auf einer freien Oberfläche des Trägersubstrats, insbesondere auf Basis von Siliziumoxynitrid SiOₓN_{y}, wobei die Zwischenschicht eine variable Zusammensetzung hat, insbesondere entlang ihrer Dicke e, so, dass die akustische Impedanz der Zwischenschicht, insbesondere allmählich, zwischen den Werten der ersten und der zweiten akustischen Impedanz variiert, und
- das piezoelektrische Substrat mit der dielektrischen Schicht mit dem Trägersubstrat mit der Zwischenschicht verbinden.

9. Verfahren zur Herstellung eines POI-Substrats nach Anspruch 8, wobei das Verbinden zwischen dem piezoelektrischen Substrat und dem Trägersubstrat zwischen der Zwischenschicht und der dielektrischen Schicht hergestellt ist.

10. Verfahren zur Herstellung eines POI-Substrats nach Anspruch 8, ferner umfassend einen Schritt des Bildens einer dielektrischen Schicht (134) auf der Zwischenschicht (106) des Trägersubstrats (102) vor dem Schritt des Verbindens, so dass anschließend das Verbinden zwischen der dielektrischen Schicht (134) des Trägersubstrats und der dielektrischen Schicht (110) des piezoelektrischen Substrats erfolgt.

11. Verfahren zur Herstellung eines POI-Substrats nach einem der Ansprüche 8 bis 10, wobei der Schritt des Bildens der Zwischenschicht auf dem Trägersubstrat das Bilden einer Schicht auf Basis von Siliziumoxynitrid SiOₓN_{y} umfasst, wobei die Stickstoffmenge gegenüber Sauerstoff in der Siliziumoxynitridschicht SiOₓN_{y}, definiert durch qt₁ = y/(y+x), entlang ihrer Dicke e₁ variiert, insbesondere mit qt₁ = 0 an der Schnittstelle zu der dielektrischen Schicht und mindestens qt₁ = 0,4 an der Schnittstelle zu dem Trägersubstrat.

12. Verfahren zur Herstellung eines POI-Substrats nach Anspruch 8, wobei der Schritt des Bildens der Zwischenschicht auf dem Trägersubstrat das Bilden einer Schicht auf Basis von Siliziumoxynitrid SiOₓN_{y} (144) umfasst, wobei die Menge qt₂ der Siliziumoxynitridschicht SiOₓN_{y}, definiert durch qt₂ = y/(y+x), entlang ihrer Dicke e₂ variiert, insbesondere mit mindestens qt₂ = 0,4 an der Schnittstelle zu dem Trägersubstrat, und das Verfahren ferner einen Schritt des Bildens einer Schicht SiOₓN_{y} (150) auf der dielektrischen Schicht (110) des piezoelektrischen Substrats (128) vor dem Montageschritt umfasst, wobei die SiOₓN_{y}-Schicht eine Menge qt₃ der Siliziumoxynitridschicht SiOₓN_{y} aufweist, die durch qt₃= *y*/*(y+x)* definiert ist und entlang ihrer Dicke e₃ variiert, insbesondere qt₃ = 0 an der Schnittstelle mit der dielektrischen Schicht des piezoelektrischen Substrats,
so, dass das Verbinden anschließend zwischen der Schicht SiOₓN_{y} (144) des Trägersubstrats und der Schicht SiOₓN_{y} (150) des piezoelektrischen Substrats hergestellt wird, wobei qt₂ gleich qt₃ an der Schnittstelle zwischen den Schichten SiOₓN_{y} des piezoelektrischen Substrats und des Trägersubstrats ist.

13. Verfahren zur Herstellung eines POI-Substrats nach einem der Ansprüche 8 bis 12, ferner umfassend einen Schritt des Bildens einer Einschlussschicht (116) auf dem Trägersubstrat (102), insbesondere einer Schicht auf Basis von polykristallinem Silizium.

14. Verfahren zur Herstellung eines POI-Substrats nach einem der Ansprüche 8 bis 13, wobei der Schritt des Bildens der Zwischenschicht durch eine Hochfrequenz-Sputterabscheidung in einer gemischten Sauerstoff- und Stickstoffatmosphäre erfolgt.

15. Oberflächenakustische Wellenvorrichtung, SAW, umfassend ein POI-Substrat (100, 200) nach einem der Ansprüche 1 bis 7.

## Claims

1. A piezoelectric-on-insulator, POI, substrate (100, 200) comprising:
- a supporting substrate (102) having a first acoustic impedance,
- a piezoelectric layer (104), in particular a layer of Lithium Tantalate, LTO, Lithium Niobate, LNO, Aluminium Nitride, AIN, Lead Zirconate Titanate, PZT, Langasite or Langatate,
- a dielectric layer (110) having a second acoustic impedance and sandwiched between the piezoelectric layer (104) and the supporting substrate (102),
- an intermediate layer (106) positioned between the supporting substrate (102) and the dielectric layer (110),
**characterised in that**
the intermediate layer (106) is a layer with a variable composition, in particular along its thickness, such that the acoustic impedance of the intermediate layer (106) varies, in particular gradually, between the values of the first and second acoustic impedances.

2. The POI substrate (100, 200) according to claim 1, wherein the supporting substrate (102) is a silicon-based substrate, the dielectric layer (110) is a layer of silicon oxide and the intermediate layer (106) is a layer of silicon oxynitride SiOₓN_{y} having a variable oxygen composition and/or a variable nitrogen composition.

3. The POI substrate (100, 200) according to claim 1 or 2, wherein the variation of the composition of the intermediate layer (106) is a gradual variation that is linear or in stages.

4. The POI substrate (100, 200) according to one of claims 1 to 3, wherein the variable composition of the intermediate layer (106) of the quantity qt of the variable composition of the layer of silicon oxynitride SiOₓN_{y} (106) is defined by qt= y/(y+x) and varies along its thickness, in particular with qt = 0 at the interface (112) with the dielectric layer (110) and at least qt = 0.4 at the interface (108) with the supporting substrate (102).

5. The POI substrate (100, 200) according to claim 4, wherein the quantity qt at the interface (108) with the supporting substrate (102) is equal to about 0.5 for an Si type supporting substrate (102) with an orientation (100), qt is equal to about 0.68 for an Si type supporting substrate (102) with an orientation (110) and qt is equal to about 0.7 for an Si type supporting substrate (102) with an orientation (111).

6. The POI substrate (100, 200) according to claim 4 or 5, wherein the quantity qt of the layer of silicon oxynitride SiOₓN_{y} (106) varies increasingly between the interface (112) with the dielectric layer (110) of the piezoelectric layer (104) and the interface (108) with the supporting substrate (102), in particular increasingly in stages or linearly.

7. The POI substrate (100, 200) according to one of claims 1 to 6, further comprising a trapping layer (116) on the supporting substrate (102), in particular a polycrystalline silicon-based layer.

8. A method for producing a POI substrate according to one of claims 1 to 7 comprising the steps of:
- providing a supporting substrate (102) having a first acoustic impedance, in particular a silicon-based substrate,
- providing a piezoelectric substrate (128), in particular a Lithium Tantalate, LTO, Lithium Niobate, LNO, Aluminium Nitride, AIN, Lead Zirconate Titanate, PZT, Langasite or Langatate substrate,
- forming a dielectric layer (110) having a second acoustic impedance on the piezoelectric substrate, in particular a layer of silicon oxide,
- forming an intermediate layer (106) on a free surface of the supporting substrate, particularly based on silicon oxynitride SiOₓN_{y}, the intermediate layer having a variable composition, in particular along its thickness e, such that the acoustic impedance of the intermediate layer varies, in particular gradually, between the values of the first and second acoustic impedances, and
- assembling the piezoelectric substrate with the dielectric layer with the supporting substrate with the intermediate layer.

9. The method for producing a POI substrate according to claim 8, wherein the assembly between the piezoelectric substrate and the supporting substrate is carried out between the intermediate layer and the dielectric layer.

10. The method for producing a POI substrate according to claim 8, further comprising a step of forming a dielectric layer (134) on the intermediate layer (106) of the supporting substrate (102) before the assembly step, such that the assembly is subsequently carried out between the dielectric layer (134) of the supporting substrate and the dielectric layer (110) of the piezoelectric substrate.

11. The method for producing a POI substrate according to one of claims 8 to 10, wherein the step of forming the intermediate layer on the supporting substrate comprises forming a layer based on silicon oxynitride SiOₓN_{y} wherein the quantity of nitrogen relative to oxygen in the layer of silicon oxynitride SiOₓN_{y} defined by qt₁ = y/(y+x) varies along its thickness *e₁*, in particular where qt₁ = 0 at the interface with the dielectric layer and at least qt₁ = 0.4 at the interface with the supporting substrate.

12. The method for producing a POI substrate according to claim 8, wherein the step of forming the intermediate layer on the supporting substrate comprises forming a layer based on silicon oxynitride SiOₓN_{y} (144)
wherein the quantity qt₂ of the layer of silicon oxynitride SiOₓN_{y} defined by qt₂ = *y*/*(y+x)* varies along its thickness *e₂*, in particular with at least qt₂ = 0.4 at the interface with the supporting substrate, and
the method further comprises a step of forming an SiOₓN_{y} layer (150) on the dielectric layer (110) of the piezoelectric substrate (128) before the assembly step, said SiOₓN_{y} layer having a quantity qt₃ of the layer of silicon oxynitride SiOₓN_{y} defined by qt₃ = y/(y+x) varying along its thickness e₃, in particular qt₃ = 0 at the interface with the dielectric layer of the piezoelectric substrate,
such that the assembly is subsequently carried out between the SiOₓN_{y} layer (144) of the supporting substrate and the SiOₓN_{y} layer (150) of the piezoelectric substrate where qt₂ is equal to qt₃ at the interface between the SiOₓN_{y} layers of the piezoelectric substrate and the supporting substrate.

13. The method for producing a POI substrate according to one of claims 8 to 12, further comprising a step of forming a trapping layer (116) on the supporting substrate (102), in particular a polycrystalline silicon-based layer.

14. The method for producing a POI substrate according to one of claims 8 to 13, wherein the step of forming the intermediate layer is carried out by radio frequency sputtering deposition in a mixed oxygen and nitrogen atmosphere.

15. A surface acoustic wave, SAW, device comprising a POI substrate (100, 200) according to one of claims 1 to 7.
